# EUROPEAN PATENT APPLICATION

(11) **EP 2 701 477 A1**
(43) Date of publication of application: **26.02.2014**
(21) Application number: 12181155.8
(22) Date of filing: 21.08.2012
(51) Int. Cl.: H05K 7/14, H05K 9/00

(54) **Enclosure for an electronic device**

(71) Applicant: ABB Technology AG, 8050 Zürich (CH)
(72) Inventor: Cottet, Didier, 8050 Zürich (CH); Agostini, Francesco, 4800 Zofingen (CH); Cimino, Mikael, 40140 Soustons (FR); Velthuis, Rudi, 79787 Lauchringen (DE); Gradinger, Thomas, 5032 Rohr (CH); Kuhn, Erich, 5436 Würenlos (CH); Grünig, Frank, 5234 Villingen (CH)
(74) Representative: ABB Patent Attorneys

(57) **Abstract**

An enclosure (10) for an electronic device (20) is provided. The enclosure comprises an enclosure wall (30) comprising a dielectric material, a first conductive layer (40) abutting an inner face (50) of the enclosure wall (30), and a second conductive layer (60) abutting an outer face (70) of the enclosure wall (30), wherein the first and the second conductive layers (40, 60) are electrically insulated from each other and are electrically connectable to predefined electric potentials, so that the electric field in the enclosure wall (30) can be homogenized in an operational state of the enclosure (10). Further, an electronic device and electronic system are provided, comprising such enclosures and electronic circuits located therein.

## Description

### TECHNICAL FIELD

The present disclosure relates to the insulation of electric and electronic components in an enclosure. In particular, the invention relates to a modular electric and/or electronic system with components located in an enclosure, more particularly, wherein the modules can be adapted to be located in a cabinet with other modules.

### BACKGROUND OF THE INVENTION

Power electronics building blocks (PEBB) are used in wide field of applications, for example in voltage conversion. Thereby, particularly in the medium to high voltage range, it is a demanding task to integrate the involved semiconductor based circuitry in an economic space, and to simultaneously fulfill the requirements with respect to heat dissipation, i.e. cooling, and safety against both the risk of electric shocks and the problem of partial discharges.

Some attempts have been made to insulate such PEBBs by solid materials, e.g. by using dielectric housings. Examples for such concepts can be found in Berth M.: "New Main Circuits, HV-Design of Submodules", ABB-Report, HIP49/ATP5-3, and in Steiner M., Reinold, H.: "Medium Frequency Topology in Railway Applications", European Railway Review (EPE), 2007, Aalborg, Denmark. However, none of these approaches has as of yet led to an application in marketable PEBB products, partly due to persisting problems with partial discharges.

In view of the above, there is a need for power electronics modules which avoid the disadvantages of the known solutions.

### SUMMARY OF THE INVENTION

The problems mentioned above are at least partly solved by an enclosure according to claim 1 and an electronic device according to claim 9.

In a first aspect, an enclosure for an electronic device is provided. It includes an enclosure wall including a solid dielectric material, a first conductive layer abutting an inner face of the enclosure wall, and a second conductive layer abutting an outer face of the enclosure wall, wherein the first and the second conductive layers are electrically insulated from each other and are electrically connectable to predefined electric potentials, so that the electric field in the enclosure wall can be homogenized in an operational state of the enclosure.

In a second aspect, an electronic device is provided. It includes an electronic circuit, and an enclosure, including a wall of a dielectric material, a first conductive layer abutting an inner face of the enclosure wall, and a second conductive layer abutting the outer face of the enclosure wall, wherein the first and the second layers are electrically insulated from each other, and wherein the first conductive layer is connected to a first electric potential of the electronic circuit, and the second conductive layer is connected to a second electric potential of the electronic circuit.

Further aspects, advantages and features of the present invention are apparent from the dependent claims, the description and the accompanying drawings.

### BRIEF DESCRIPTION OF THE DRAWINGS

A full and enabling disclosure, including the best mode thereof, to one of ordinary skill in the art is set forth more particularly in the remainder of the specification, including reference to the accompanying figures wherein:

Fig. 1 schematically shows a partial cross-sectional view of an enclosure according to embodiments;

Fig. 2 schematically shows a perspective front view of an electronic module according to embodiments;

Fig. 3 schematically shows a front view of an electronic system according to embodiments;

Fig. 4 schematically shows a perspective front view of the system shown in Fig. 3.

Fig. 5 schematically shows a cross sectional side view of a system according to embodiments.

Fig. 6 schematically shows a simulation of the electric field inside an exemplary modular electronic system.

Fig. 7 schematically shows a simulation of the electric field inside a modular electronic system according to embodiments.

### DETAILED DESCRIPTION OF THE INVENTION

Reference will now be made in detail to various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

Within the following description of the drawings, the same reference numbers refer to the same components. Generally, only the differences with respect to the individual embodiments are described. When several identical items or parts appear in a figure, not all of the parts have reference numerals in order to simplify the appearance.

The systems and methods described herein are not limited to the specific embodiments described, but rather, components of the systems and/or steps of the methods may be utilized independently and separately from other components and/or steps described herein. Rather, the exemplary embodiment can be implemented and used in connection with many other applications.

Although specific features of various embodiments of the invention may be shown in some drawings and not in others, this is for convenience only. In accordance with the principles of the invention, any feature of a drawing may be referenced and/or claimed in combination with any feature of any other drawing.

Generally, embodiments of the invention pertain to an enclosure respectively housing for medium to high voltage electronic circuits, i.e. power switches, together forming an electronic module, for example a PEBB. Each enclosure includes a dielectric material, which has a conductive layer on both the inside and the outside. Several enclosures may be arranged in an array, for example an m x n matrix (i.e. an m by n matrix). Thereby, the enclosures may be arranged such that they can be fitted respectively mounted to each other via mounting elements on the outer faces of the enclosures. In embodiments, the enclosures may be pullably mounted in a rack, so that the electrical contacts are typically provided on their rear side. The term "medium voltage" mentioned above is understood as a rated voltage of about 1000 Volts up to about 36000 Volts (DC, or rms voltage in case of AC). A voltage higher than this is regarded hereinafter as "high voltage". One has to be aware that the equipment must be able to withstand impulse voltages (e.g. a lightning impulse) that are typically much higher (e.g. above 100 kV) even for MV equipment. See e.g. IEC 61800-5-1, Tab. 8 for reference.

The dielectric material of the enclosure fulfils the standards for solid insulation to ground, i.e. a dielectric material that is capable of establishing the electric insulation within the enclosure. The thickness of the dielectric wall is dimensioned according to the breakdown strength of the material and the applied voltages. Thereby, the inner wall of the enclosure coated with the first conductive layer is, in an operational state of the respective electronic module, connected to a defined potential, and the outer wall coated with the second conductive layer is connected to a second potential.

Thereby, the two conductive layers form a nearly homogeneous electric field in the dielectric material there between. In embodiments, the outer layer is typically on ground potential, whereas the inner layer may typically be connected to a voltage of the electronic circuit inside the electronic module. This configuration allows for a highly effective insulation of the medium to high voltage circuit inside the enclosure with respect to the surroundings, as the outer conductive layer of the enclosure is on ground potential. Thus, the potential difference between the voltage of the circuit and ground forms a nearly homogeneous electric field inside the dielectric material of the enclosure. The thickness of the enclosure has to be chosen in view of the voltage used for operating the circuit and the dielectric properties of the material chosen, especially the breakdown strength. Typically, the enclosure is formed such that the conductive layers on the inside and outside have a smooth surface and are substantially free of sharp edges, small radiuses etc, so that the field between the inner and outer layer during operation does not exhibit local peak values, which might promote partial discharge.

The enclosure may have a variety of shapes; typically it has the shape of a cuboid, respectively a box. It may, however, also have a hexagonal shape or be a combination of more than one cuboid of different sizes or shapes. Typically, the enclosure or box has openings on its front and back, respectively on two opposite surfaces, which serve as clearings for cooling air for the electronic circuitry in the interior. Hence, the enclosure forms a kind of channel from front to back for air cooling. At the front and the back, where the enclosure has the openings, the conductive layers on the inner wall and outer wall of the enclosure are terminated, such as to fulfill the insulation standards for air clearance and creepage. In embodiments, depending on the individual setup, also ripples can be provided/structured in the dielectric material of the enclosure, in order to extend the creepage surface distance.

In embodiments, which can be combined with other embodiments described herein, the openings in the front and back may be provided with a grill respectively grid structure to protect from touching according to insulation standards, e.g. high voltage insulation standards. This grill structure is typically connected to the outer conductive layer which is electrically connected to ground potential.

Depending on the voltages applied, the inner and outer layers may also be connected to different potentials than as described before, for example the inner layer may be connected to a potential lower than the working potential of the electronic circuit, or the outer layer may also be connected to a non-ground potential, for example between ground and the working potential. In this case, measures have to be taken in order to insulate the touchable outer layer from the surroundings, respectively to secure it against touching.

In embodiments, the enclosure may be a frame. This means, that there are openings not only - as described before - in the front and back surfaces (wherein front and back may be defined with respect to the resulting air channel, or also with respect to the direction in which the enclosure/module may be inserted into a rack or an array of other enclosures/modules), but also other faces of the cuboid have openings, such that in an embodiment, the enclosure is a box-shaped frame having openings instead on all the side surfaces.

Thereby, embodiments pertain to an electronic system including a plurality of the described electronic modules. The modules are typically arranged in an array. Either, the enclosures of the modules exhibit elements in their outer surfaces which serve as mounting means to connect the various modules to each other, for example rails and/or grooves. Or, the modules are mounted in a frame, cabinet or rack having openings, rails, grooves or other standard means for mounting purposes. The electronic modules can be plugged in or out from the array - in any of the individual setups as described above - and may also include hot-plug-facilities, for example that the electrical contacts are provided on the back of the modules, so that they enter the slot first during plugging in.

In embodiments, the modules themselves may also have a modular structure. Thus, the electronic circuit board is mounted inside the enclosure with detachable means, such as rails. For access to the inside of the electronic module, hence the circuit, one surface of the enclosure is typically configured that it can be opened for removing the circuit board. Thus, the electronic system including the enclosures arranged in an array has a two-stage or double modular structure. On the one hand, the electronic modules including the enclosure and the circuit therein may be detached from the system. By doing so, the system may for example be scaled to various power requirements or cost requirements quickly and with great flexibility. At the same time or additionally, the circuit boards may be removed or inserted individually into the single enclosures of modules.

Embodiments according to the invention allow a compact design due to the defined nearly homogeneous electric field in the dielectric layer, which allows for a highly effective insulation of medium to high voltages requiring only very little space. Hot swapping of modules and/or electronic circuits in the modules is obtainable. Due to the effective insulation principle, small form factors for the modules are possible, respectively little air space is required between the electronic circuits and the housing. Depending on the embodiment, small and at the same time lightweight modules and entire systems can be obtained. As the modules in an array can be connected to ground with their respective outer conductive layers, a grounded system, safe for contact by personnel can be obtained.

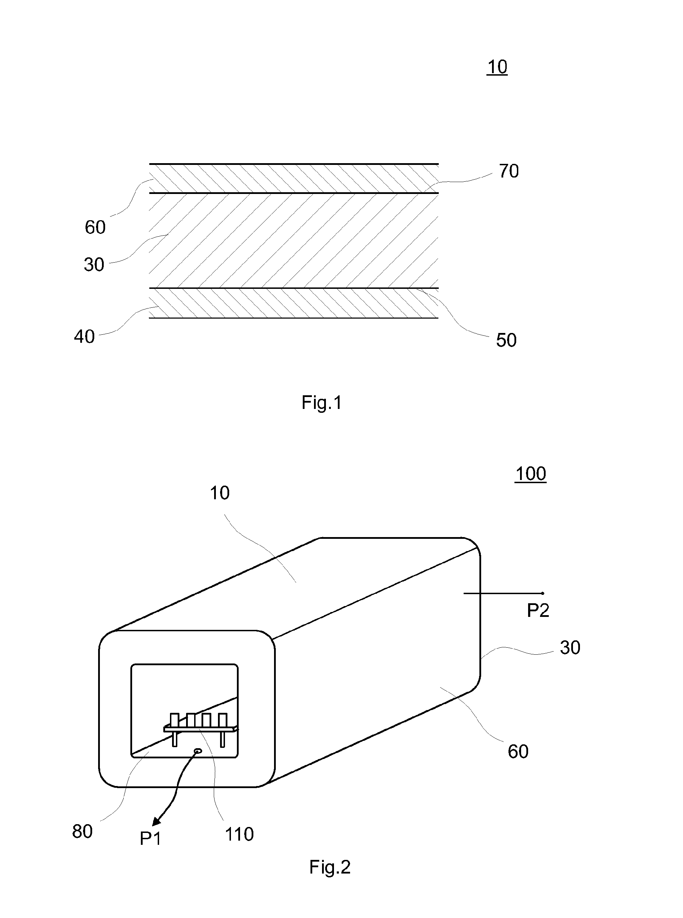

Fig. 1 shows a cross-sectional view of an enclosure 10 according to embodiments. It includes a dielectric material 30 which is abutted on both faces 50, 70 with conductive layers 40 and 60. Depending on the requirements and the use of the enclosure, the enclosure wall 30 comprises at least one of a polymer plastic, e.g. polyurethane, a fiber reinforcement, e.g. for forming an FRP, a polymer resin and a ceramic. The fiber reinforcement may include wood or cellulose based materials, where suitable. Particularly in embodiments where the enclosure wall 30 includes at least one of a polymer and a fiber reinforced plastic, for example polyurethane, the enclosure may be produced integrally from one piece, for example by one of injection molding, compression molding, casting, or pultrusion.

The electrically conductive layers may comprise a metal or metal alloy, but may also include non-metallic conductive materials such as carbon in its modifications. Other satifsfactory conductive layers can be established by a conductive polymer, i.e. a polymer matrix comprising conductive particles. In case of metals, they may, for example be copper, aluminum, silver, gold, an iron alloy, or alloys of any of the former. If the electrically conductive layer is a polymer, too, it might be molded on the enclosure wall 30 at the time of manufacturing the latter or shortly thereafter.

Fig. 2 shows an electronic module 100 according to embodiments. It has - not limiting - two ventilation openings (only the front opening 80 visible), a circuit board 110, and an enclosure 10 having the properties as described with respect to Fig. 1 above. The thickness of the dielectric material 30 is dimensioned according to the breakdown strength of the material and the applied voltages. Thereby, the inner wall of the enclosure, coated with the first conductive layer 40 is, in an operational state of the electronic module 100, connected to a defined potential P1 while the outer wall coated with the second conductive layer 60 is connected to a second potential P2.

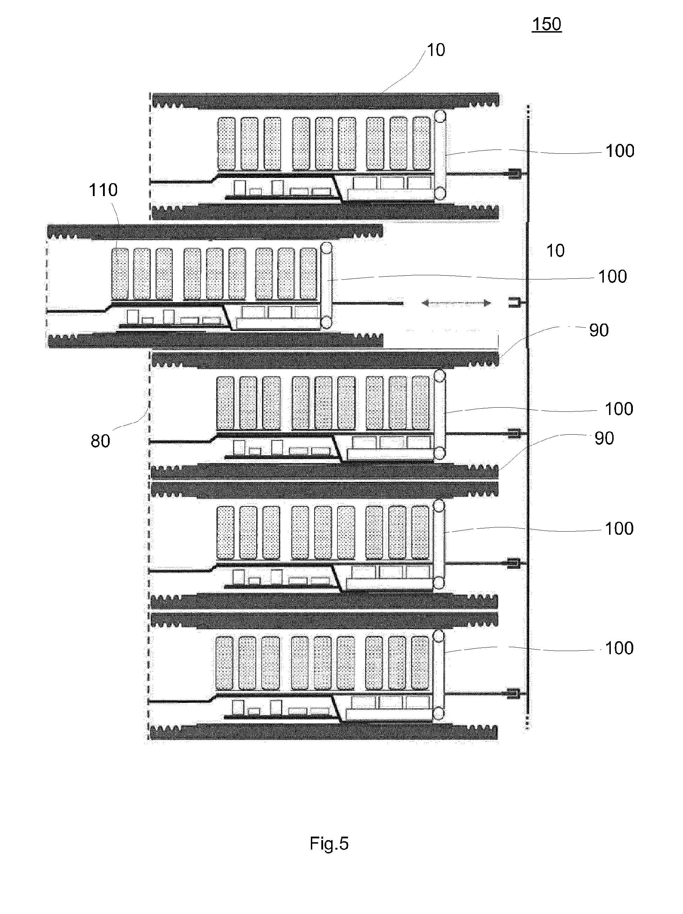

As shown in Fig.2, the connection of the first conductive layer 40 to the potential P1 may be on a front side or on a rear side with respect to the insertion direction into the cabinet 160. The connection means for establishing the electrical connection for potential P1 may be designed to be flexible or rigid, e.g. a cable or a plug, respectively, depending on the contacting scheme of the electronic modules 100 and the cabinet 160. If required the connection means for establishing the electrical connection to potential P1 can be formed as a plug on the rear side of the the electronic module 100 such that the connection can be plugged when the module is pushed into a rack or cabinet 160 (see Fig. 5 for reference).

As shown in Fig.2, the connection of the second conductive layer 60 to the potential P2 may be provided on a lateral side of the electronic modules 100 with respect to the insertion direction into the cabinet 160. The connection means for establishing the electrical connection for potential P2 may be designed to be flexible or rigid, e.g. a cable or a plug, respectively, depending on the contacting scheme of the electronic modules 100 and the cabinet 160. As an alternative, the connection means for establishing the electrical connection to potential P2 can be formed likewise to the one of potential P1 as a plug on the rear side of the the electronic module 100 instead such that the connection can be plugged when the module is pushed into a rack or cabinet 160, too (see Fig. 5 for reference). As an alternative, either the electronic modules 100 or the rack or cabinet 160 can feature a contacting system for contacting the second conductive layer 60 of two neighboring electronic modules 100, wherein the contacting system may comprise a spring-like contacting element, e.g. a contacting tongue, for establishing an electric contact to the second conductive layer 60 concerned at the time of inserting a electronic module 100 into the rack or cabinet 160 automatically. Such a contacting system is advantageous in turns of safety since the electrical connection to potential P2 is established automatically and thus not relying on humans' attention after inserting of the module 100 into the rack 160.

In any case, the two conductive layers 40, 60 form a homogeneous electric field in the dielectric material there between. In embodiments, the outer layer 60 is typically on ground potential P2, whereas the inner layer 40 may typically be connected to a voltage P1 of the electronic circuit 110 inside the electronic module 100. Thereby, a highly effective insulation of the medium to high voltage circuit 110 inside the enclosure 10 with respect to the surroundings is achieved. Thus, the potential difference P2 - P1 between the voltage of the circuit 110 and ground forms a nearly homogeneous electric field inside the dielectric material 30 of the enclosure 10, which has an approximate field strength of P2 - P1 divided by the thickness of the dielectric material of the enclosure. Typically, the enclosure is formed such that the conductive layers on the inside and outside have a smooth surface and are substantially free of sharp edges, very small radiuses etc., so that the field between the inner and outer layer during operation does not exhibit local peak values, which might promote partial discharge.

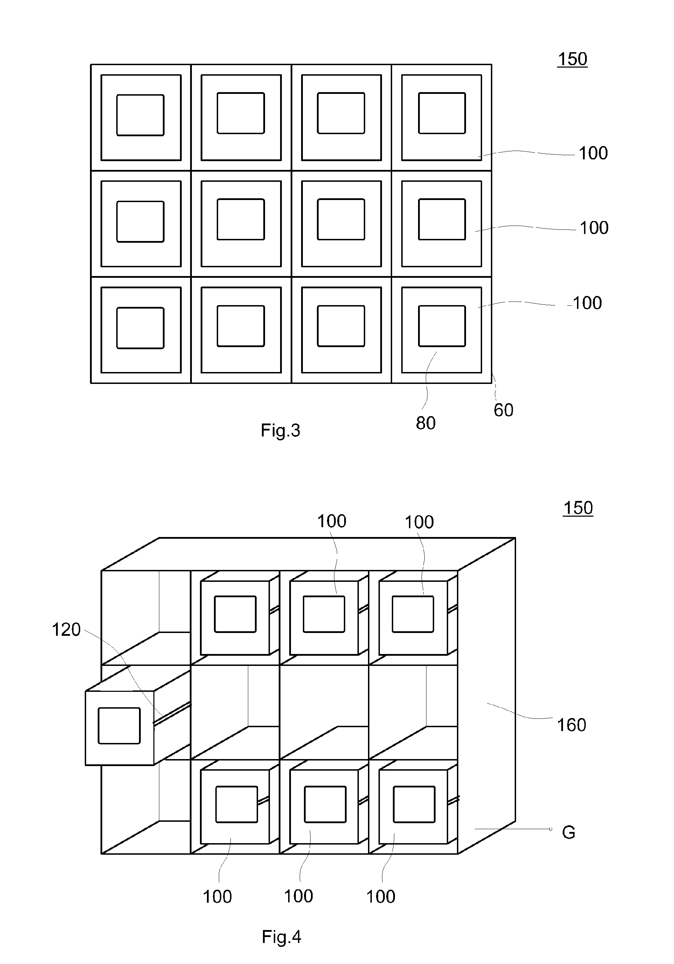

Fig. 3 schematically shows an electronic system 150 according to an embodiment. A plurality of electronic modules 100 according to embodiments are stacked in an array defining an x and y plane (here the drawing plane).

Fig. 4 shows another view of the system of Fig. 3. The modules 100 may typically, but not necessarily be arranged in an m x n matrix as shown. Thereby, the enclosures of the modules 100 typically exhibit elements on or in their outer surfaces which serve as mounting means to connect the various modules, for example rails 120 and/or grooves. Or, the modules are mounted in a frame, cabinet 160 or rack having rails 120, grooves or other standard means for mounting purposes. The electronic modules (PEBB's) can be plugged in or out from the system 150 - in any of the individual setups as described above. The cabinet 160 structure itself can be conveniently connected to electric ground potential if required by safety reasons.

This is schematically shown in Fig. 5. Therein, a side cross sectional view of a system similar to that in Fig. 3 and 4 is shown. Five modules are stacked in a rack 160. Thereby, the earlier described exchangeability of an electronic circuit 110 within a module 100 is shown. That is, one PEBB is extractable out of and insertable into a modular electronic system 150 in the direction of the arrow indicated while the other PEBB's remain plugged connection to the rack 160 is unplugged. Also, a design with ripples 90 at the end of the enclosure 10 towards opening 80 is shown in order to increase withstand against creepage.

The various modules 100 in Fig. 3, 4, and 5 are typically collectively connected to a ground potential with the outer conductive layer, so that prevention against electric shock is provided.

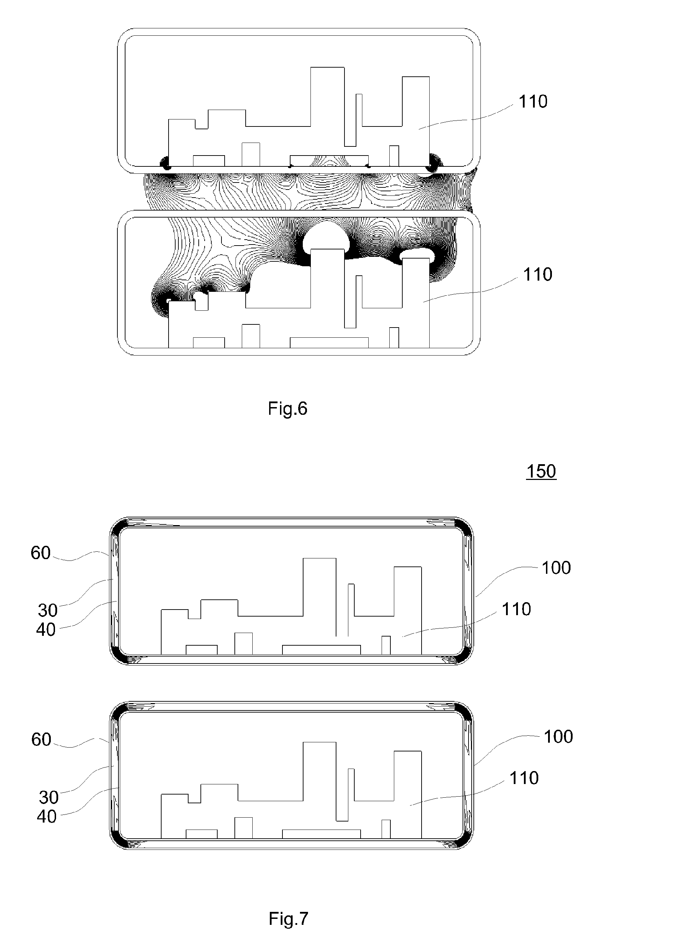

Fig. 6 schematically shows a plot of a computational simulation of the electric field inside an exemplary modular electronic system according to conventional technology, having dielectric housings around the electronic circuits 110. Two modules are shown, wherein the electronic circuits 110 inside the housings are on the same test potential. It can be seen that the electric field lines exhibit a highly irregular spatial distribution, also in the space between the housings, indicating field peaks and leading to a significant risk of partial discharges.

Fig. 7 schematically shows a simulation of the electric field inside a modular electronic system 150 according to embodiments. The electronic circuits 110 are on the same potential as the respective first or inner layers 40 of the modules 100. An electric field is located in this example between the grounded, outer layer or second layer 60, and the first layer or inner layer 40, which is on the same potential as circuit 110. Thus, the space between the two modules 100 is - in the shown example - free of an electric field, thus reducing the risk of partial discharges in the space outside the modules 100 to zero, respectively eliminating the probability of partial discharge.

The field line distribuition is only shown in the dielectric enclosure wall 30; depending on the design of the electronic circuit 110, there may also be an electric field (not shown) between portions of the circuit 110 and the inner layer 40.

This written description uses examples to disclose the invention, including the best mode, and also to enable any person skilled in the art to practice the invention, including making and using any devices or systems and performing any incorporated methods. While various specific embodiments have been disclosed in the foregoing, those skilled in the art will recognize that the spirit and scope of the claims allows for equally effective modifications. Especially, mutually non-exclusive features of the embodiments described above may be combined with each other. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. Enclosure (10) for an electronic device (20), comprising:
an enclosure wall (30) comprising a dielectric material,
a first conductive layer (40) abutting an inner face (50) of the enclosure wall (30), and
a second conductive layer (60) abutting an outer face (70) of the enclosure wall (30),
wherein the first and the second conductive layers (40, 60) are electrically insulated from each other by the enclosure wall (30) and are electrically connectable to predefined electric potentials (P1, P2) by a connection means, so that the electric field in the enclosure wall (30) can be homogenized in an operational state of the enclosure (10).

2. The enclosure (10) of claim 1, wherein at least one of the conductive layers (40, 60) comprises copper, aluminum, silver, gold, an iron alloy, or an alloy of any of the former.

3. The enclosure (10) of claims 1, wherein at least one of the conductive layers (40, 60) comprises an electrically conductive polymer.

4. The enclosure (10) of any preceding claim, wherein the enclosure wall (30) comprises at least one of a polymer, a fiber reinforced plastic and a ceramics.

5. The enclosure (10) of any preceding claim, wherein the dimensions and material of the enclosure wall (30) are dielectrically designed to permanently withstand a peak voltage of at least 5 kV between the first conductive layer (40) and the second conductive layer (60).

6. The enclosure (10) of any preceding claim, having a basically cuboid shape.

7. The enclosure of claim 6, wherein at least two faces of the cuboid comprise openings (80) for allowing ventilation, and wherein the enclosure (10) has a preferably tubular shape.

8. Enclosure according to any preceding claim, wherein the enclosure wall is made integrally from one piece, preferably by one of the following: injection molding, compression molding, casting, or pultrusion.

9. An electronic module (100), comprising:
- an electronic circuit (110), and
- an enclosure (10) housing the electronic circuit (110), comprising an enclosure wall (30) of a dielectric material,
a first conductive layer (40) abutting an inner face (50) of the enclosure wall (30), and
a second conductive layer (60) abutting the outer face (70) of the enclosure wall (30),
wherein the first and the second layers (40, 60) are electrically insulated from each other by the enclosure wall (30),
and wherein the first conductive layer (40) is connected to a first electric potential (P1) of the electronic circuit (110), and the second conductive layer (60) is connected to a second electric potential (P2).

10. The electronic module (100) of claim 9, wherein the second conductive layer (60) is connectable to ground (G) potential.

11. The electronic module (100) of claim 9 or 10, wherein the wall (30) comprises a section with ripples (90) for increasing a creepage distance.

12. A modular electronic system (150), comprising a plurality of electronic devices (100) according to claims 9 to 11.

13. A modular system (150) according to claim 12, wherein the electronic devices (100) are arranged in a rack (160).

14. A modular system (150) according to claim 12, wherein the electronic devices (100) are arrangeable in a projection plane defined by an x-axis and a y-axis in an array, preferably in an m x n matrix, and wherein the devices are adapted to be individually exchangeable by moving them in a direction perpendicular to the plane (z-axis) in a drawer-like manner.

15. A modular system (150) according to one of claims 12 to 14, wherein at least one first module (100) comprises an electrical contact which electrically connects the second conductive layer (60) of that module with a second conductive layer (60) of a second, neighboring module (100), when the first module (100) is inserted into the modular system (150).
